(19) **Europäisches Patentamt**
**European Patent Office**
**Office européen des brevets**

(11) **EP 1 307 992 B1**

(12) **EUROPEAN PATENT SPECIFICATION**

(45) Date of publication and mention
of the grant of the patent:
**15.08.2007 Bulletin 2007/33**

(51) Int Cl.:
*G10L 19/02* (2006.01)    *H04L 9/00* (2006.01)
*G10H 7/00* (2006.01)

(21) Application number: **01952901.5**

(22) Date of filing: **20.06.2001**

(86) International application number:
**PCT/US2001/041071**

(87) International publication number:
**WO 2001/099315 (27.12.2001 Gazette 2001/52)**

(54) **COMPRESSION AND DECOMPRESSION OF AUDIO FILES USING A CHAOTIC SYSTEM**

KOMPRIMIEREN UND DEKOMPRIMIEREN VON AUDIODATEIEN UNTER VERWENDUNG EINES CHAOTISCHEN SYSTEMS

COMPRESSION ET DE DECOMPRESSION DE FICHIERS SONORES A L'AIDE D'UN SYSTEME CHAOTIQUE

(84) Designated Contracting States:
**AT BE CH CY DE DK ES FI FR GB GR IE IT LI LU MC NL PT SE TR**

(30) Priority: **20.06.2000 US 597101**

(43) Date of publication of application:
**07.05.2003 Bulletin 2003/19**

(73) Proprietor: **UNIVERSITY OF NEW HAMPSHIRE**
**Durham, NH 03824-3547 (US)**

(72) Inventor: **SHORT, Kevin**
**Durham, NH 03824 (US)**

(74) Representative: **Boyce, Conor**
**F. R. Kelly & Co.,**
**27 Clyde Road,**
**Ballsbridge**
**Dublin 4 (IE)**

(56) References cited:
**US-A- 5 040 217       US-A- 5 432 697**
**US-A- 5 508 473       US-A- 5 729 607**
**US-A- 5 732 158       US-A- 5 737 360**
**US-A- 5 808 225       US-A- 5 818 712**
**US-A- 6 137 045**

• **DEDIEU H ET AL: "Signal coding and compression based on chaos control techniques" IEEE SYMPOSIUM ON CIRCUITS AND SYSTEMS, vol. 2, 28 April 1995 (1995-04-28), pages 1191-1194, XP002325883**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Jouve, 75001 PARIS (FR)

EP 1 307 992 B1

**Description**

The present invention relates generally to a method and apparatus for the efficient compression and decompression of audio files using a chaotic system. More specifically, it relates to a system for approximating a section of audio file with basic waveforms produced by applying selected digital initialization codes to a chaotic system and further processing the initialization codes to produce compressed audio files. In general, a chaotic system is a dynamical system which has no periodicity and the final state of which depends so sensitively on the system's precise initial state that its timedependent path is, in effect, long-term unpredictable even though it is deterministic.

Dedieu H et al "Signal coding and compression based on chaos control techniques" IEEE Symposium on Circuits and Systems, vol 2, 28 April 1995 - 3 May 1995 pages 1191-1194 and US-A-5 432 697, Hayes disclose applying chaotic systems to signal compression by driving them with appropriate initialisation codes.

Short, et al., Method and Apparatus for Secure Digital Chaotic Communication, U.S. Pat..No. 6,363,153 ("Short I"), describes a chaotic system controlled by a transmitter/encoder and an identical chaotic system controlled by a receiver/decoder. Communication is divided into two steps: initialization and transmission. The initialization step uses a series of controls to drive the identical chaotic systems in the transmitter/encoder and receiver/decoder into the same periodic state. This is achieved by repeatedly sending a digital initialization code to each chaotic system, driving each of them onto a known periodic orbit and stabilizing the otherwise unstable periodic orbit The necessary initialization code contains less than 16 bits of information. The transmission step then uses a similar series of controls to steer the trajectories of the periodic orbits to regions of space that are labeled 0 and 1, corresponding to the plain text of a digital message.

Short, et al., Method and Apparatus for Compressed Chaotic Music Synthesis, U.S. Pat. No.6,137,045 ("Short II"), describes the use of such an initialization step to produce and stabilize known periodic orbits on chaotic systems, which orbits are then converted into sounds that approximate traditional music notes. By sending a digital initialization code to a chaotic system, a periodic waveform can be produced that has a rich harmonic structure and sounds musical. The one-dimensional, periodic waveform needed for music applications is:achieved by taking the x-, y-, or z-component (or a combination of them) of the periodic orbit over time as the chaotic system evolves. The periodic waveform represents an analog version of a sound, and by sampling the amplitude of the waveform over time, e.g., using audio standard PCM 16, one can produce a digital version of the sound. The harmonic structures of the periodic waveforms are sufficiently varied that they sound like a variety of musical instruments.

The present invention is a system for the compression and decompression of audio files, including without limitation music and speech files. In summary, a library of basic waveforms associated with a chaotic system is produced, according to Short II and as described in detail hereafter, by applying selected digital initialization codes to the chaotic system. The basic waveforms that can be produced with 16-bit initialization codes range from simple cases that resemble the sum of a few sine waves with an associated frequency spectrum containing only two or three harmonics, to extremely complex waveforms in which the number of significant harmonics is greater than 64. Importantly, the initialization codes are 16 bits regardless of whether the basic waveforms are simple or complex. By contrast, in a linear approach, one would expect the number of bits necessary to produce a waveform to be proportional to the number of harmonics in the waveform. Equally importantly, each initialization code is in one-to-one correspondence with a specific basic waveform, allowing the use of the corresponding initialization code to represent the basic waveform. Then basic waveforms selected from the library are used to approximate a section of audio file.

The basic waveforms that are most closely related to the section of audio file are selected, and a weighted sum of the selected waveforms is used to approximate the section of audio file. Once such a weighted sum is produced that approximates the section of audio file to a specified degree of accuracy, the basic waveforms can be discarded and only the weighting factors; the corresponding initialization codes; and certain frequency information described below are stored in a compressed audio file. The compressed audio file may also contain other implementation-dependent information, e.g. header information defining sampling rates, format, etc. When the compressed audio file is decompressed for playback, the initialization codes are stripped out and used to regenerate the basic waveforms, which are recombined according to the weighting factors in the compressed audio file to reproduce the original section of audio file.

The compressed audio file can be transmitted, or stored for later transmission, to an identical chaotic system for decompression at a remote location. In practice, the remote location does not need the compression part of the system and would only use the decompression part of the system if playback of the section of audio file is all that is desired.

A further degree of compression is often possible and desirable. After finding a suitable weighted sum of basic waveforms, the weighted sum can be examined and any waveforms that contribute less to the overall approximation than a specified threshold can be eliminated. When such waveforms are identified, the corresponding initialization codes can be removed from the compressed audio file. Also, because the compression is done on sections of audio file, it is possible to look at the basic waveforms and the corresponding initialization codes to determine if there is a predictable pattern to the changes in the weighting factors from section to section. If such patterns are detected, further compression of the compressed audio file can be achieved by storing only the requisite initialization code and information about the pattern of changes for the weighting factors.

It is an object of the present invention to create compressed music files for distribution over the Internet. Compression ratios at better than 50-to-1 may be possible, which will allow for the transmission of music files over the Internet with greatly improved download speed. It is possible to estimate the compression ratio for music based on how rapidly the music changes. These estimates indicate that if the music changes on a scale of 0.02 sec, so the important changes in the music occur 50 times a second, then compression of 60-to-1 should be achievable. If the music changes on a scale of 0.04 sec, compression of 120-to-1 should be achievable. It is also an object of the present invention to replace the standard MIDI technology used in the music industry with a system that is simpler, requires less memory and offers more flexible sampling requirements.

It is also an object of the present invention to produce compressed music files that decompress rapidly. For example, in one embodiment an unoptimized $C^{++}$ program on a 300 $MH_z$ processor decompressed at better than three times faster than real time. In a more optimized version, decompression is better than 5 times faster than real time, running on a computer that is roughly equivalent to a 100MHz processor.

It is yet another object of the present invention to create compressed audio files that are encrypted. For example, music files compressed with the present invention are naturally encrypted in accordance with Short I. In order to be able to decompress properly a compressed music file, it is necessary to have the proper chaotic decompressor. These decompressors could be distributed freely or to a group of registered users, thus allowing for some control over the distribution and reproduction of the compressed music files. Even greater control of the uses of the compressed music files can be achieved by incorporating a secondary layer of a secure chaotic distribution channel, using the technology described in Short I, to encode the digital bits of the compressed music files before transmitting them to a user. Since registered users can be given unique chaotic decoders, it will be possible to place a "security wrapper" around the compressed music files, so that only a registered user will be able to access the music. It will also be possible to structure the security wrapper so that a song can be played only once without paying a fee.

## SUMMARY OF THE INVENTION

A new system for the compression and decompression of audio files is provided. A library of basic waveforms is produced by applying selected digital initialization codes to a chaotic system. Each initialization code produces and stabilizes an otherwise unstable periodic orbit on the chaotic system. The basic waveforms needed are achieved by taking the x-, y-, or z-component (or a combination of them) of the periodic orbits over time. The basic waveforms that can be produced with 16-bit initialization codes range from simple to complex, and each basic waveform is in one-to-one correspondence with an initialization code.

The basic waveforms in the library that are most closely related to a section of audio file to be compressed are selected, and a weighted sum of the selected basic waveforms is used to approximate the section of audio file. Once such a weighted sum is produced to approximate the section of audio file to a specified degree of accuracy, the basic waveforms can be discarded and only the weighting factors and the corresponding initialization codes, as well as certain frequency information, are stored in a compressed audio file. When the compressed audio file is decompressed for playback, the stored initialization codes are stripped out and used to regenerate the basic waveforms, which are recombined according to the stored weighting factors to reproduce the original section of audio file.

A further degree of compression may be achieved if, after finding a suitable weighted sum of basic waveforms, any basic waveforms may be eliminated. Also, if there is a predictable pattern to changes in the weighting factors from section to section, further compression can be achieved by storing only the requisite initialization code and information about the pattern of changes for the weighting factors.

The foregoing and other objects, features and advantages of the present invention, which is defined by the appended independent claims, will be apparent from the following detailed description of preferred embodiments of the invention as illustrated in the accompanying drawings.

## IN THE DRAWINGS

Fig. 1 is a block diagram of a compression and decompression system for audio files according to an embodiment of the present invention.

Fig. 2 is a flow chart showing the steps in general in a compression system for audio files according to an embodiment of the present invention.

Fig. 3 is a flow chart showing in greater detail the creation of a library of basic waveforms according to an embodiment of the present invention..

Fig. 4 is a plot of the double scroll oscillator resulting from the given differential equations and parameters.

Fig. 5 is a plot of the function r(x) for twelve loops around the double scroll oscillator.

Fig. 6 is a plot of the periodic orbit of the double scroll oscillator resulting from a 5-bit initialization code (01011).

Fig. 7 is a plot of a section of music file.

Fig. 8 is a plot of the value in $V_{peaks}$.

Fig. 9 is a plot of the full periods of three basic waveforms.

Fig. 10 is a plot of the full periods of three basic waveforms after phase and frequency adjustment.

Fig. 11A is a plot of a section of a music file.

Fig. 11B is a plot of a first approximation of a section of music file using basic waveforms.

## DETAILED DESCRIPTION OF THE INVENTION

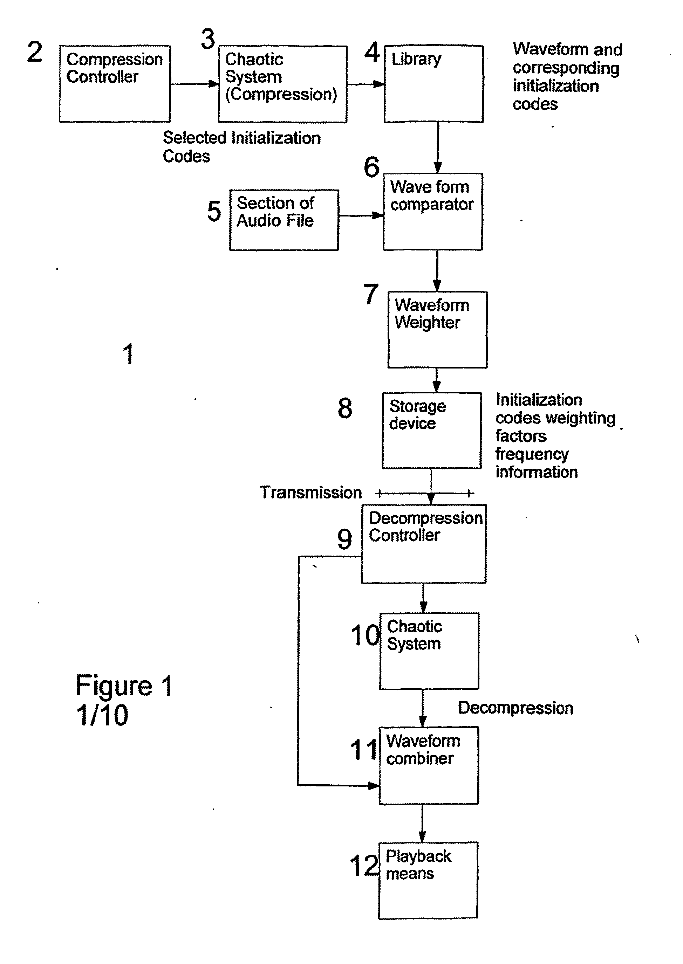

A block diagram of an embodiment of the present invention is contained in Fig. 1. The system 1 for compression and decompression of audio files comprises a compression controller 2 to apply selected digital initialization codes to a selected chaotic system 3. Each initialization code produces a basic waveform that is stored in a library 4 with its corresponding initialization code. A section of audio file to be compressed 5 is analyzed in a waveform comparator 6, which then selects the basic waveforms in the library 4 that are most closely related to the section of audio file to be compressed 5 and their corresponding initialization codes. A waveform weighter 7 then generates a weighted sum of the selected basic waveforms to approximate the section of audio file 5 and the weighting factors necessary to produce the weighted sum. The basic waveforms are then discarded and only the weighting factors and the corresponding initialization codes comprise a compressed audio file, which is stored in a storage device 8. For decompression and playback, the compressed audio file is transmitted to a remote decompression controller 9, which strips out the stored initialization codes and applies them to chaotic system 10 that is identical to the chaotic system 3 used in compression. Each initialization code produces a basic waveform that is sent to a waveform combiner 11. The decompression controller also sends the stored weighting factor to the waveform combiner 11. The basic waveforms are combined in the waveform combiner 11 according to the weighting factors to reproduce the original section of audio file for playback through the customary means 12 for playback of a section of digital audio file.

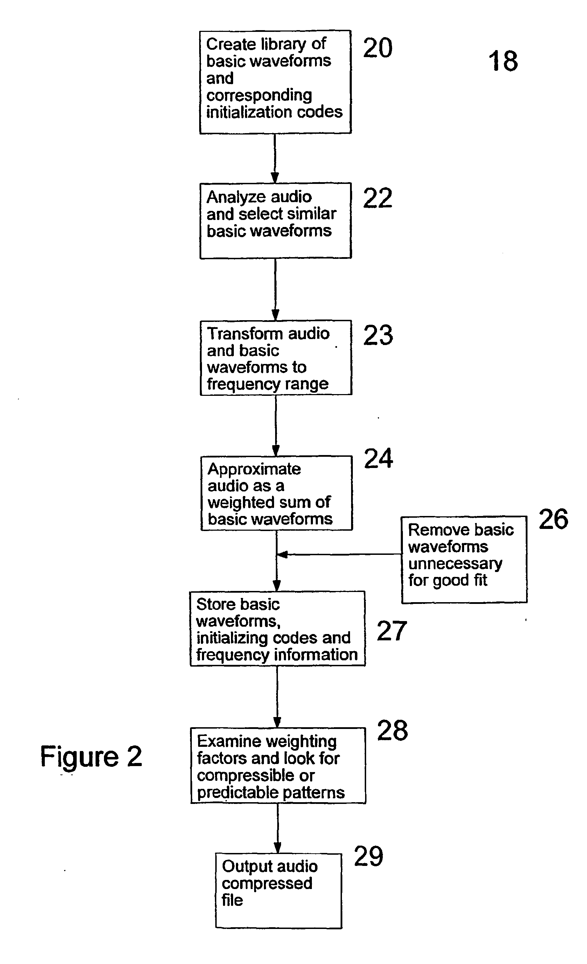

A flowchart of a preferred embodiment of the present invention, in general, for compression of audio files is shown in Fig. 2. The process begins with step 20 in which a library of basic waveforms and corresponding initialization codes is compiled as described in detail below. The library contains all of the basic waveforms and corresponding initialization codes for a particular chaotic system. In addition, key reference information about the waveforms can be stored efficiently in a catalog file. The information in the library can be static for a given embodiment. In most applications, the catalog file contains all relevant information and can be retained while the waveforms can be discarded to save storage space.

The present invention uses digital initialization codes to drive a chaotic system onto periodic orbits and to stabilize the otherwise unstable orbit. Each periodic orbit then produces a basic waveform that has a traditional musical sound since it includes the harmonic overtones that give different instruments their distinctive qualities. Consequently, instead of producing a single pitch (i.e., a sine wave) at the root frequency, as might be produced by a tone generator, the periodic orbit contains overtones at multiples of the root frequency. In a preferred embodiment of the present invention in which a double scroll oscillator is the chaotic system used, each periodic orbit corresponds to a basic waveform with a natural harmonic structure that is related to the number of loops that take place around one lobe before moving off to the next lobe. Consequently, the variety of different periodic orbits produces basic waveforms, which correspond to different musical instruments. Thus, a group of initializing codes may produce basic waveforms that have the tonal qualities of a harpsichord; another group may produce basic waveforms that sound more like an electric guitar; another group may produce basic waveforms that sound like an electric piano, and so on.

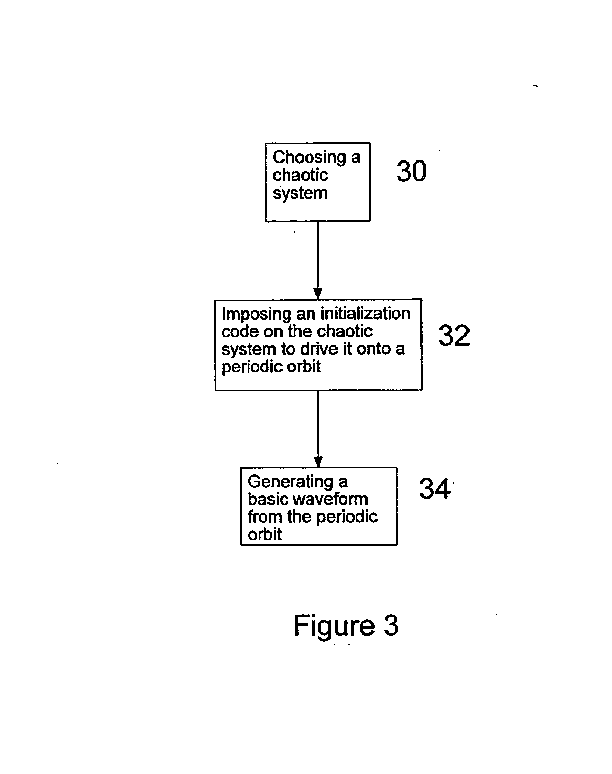

Fig. 3 is a flow chart showing in greater detail the creation of the library of basic waveforms and corresponding initialization codes for a preferred embodiment. The first step 30 is choosing a chaotic system, to be driven onto periodic orbits to produce the basic waveforms. In a preferred embodiment, the chaotic system is a double-scroll oscillator [S. Hayes, C. Grebogi, and E. Ott, Communicating with Chaos, Phys, Rev. Lett. 70, 3031 (1993)], described by the differential equations

$$C_1\dot{v}_{C1} = G(v_{C2} - v_{C1}) - g(v_{C1})$$

$$C_2\dot{v}_{C2} = G(v_{C1} - v_{C2}) + i_L$$

$$\dot{L\dot{i}}_L = -v_{C2},$$

where

$$g(v) = \begin{cases} m_1 v, & \text{if } -B_p \leq v \leq B_p; \\ m_0(v + B_p) - m_1 B_p, & \text{if } v \leq -B_p; \\ m_0(v - B_p) + m_1 B_p, & \text{if } v \geq B_p. \end{cases}$$

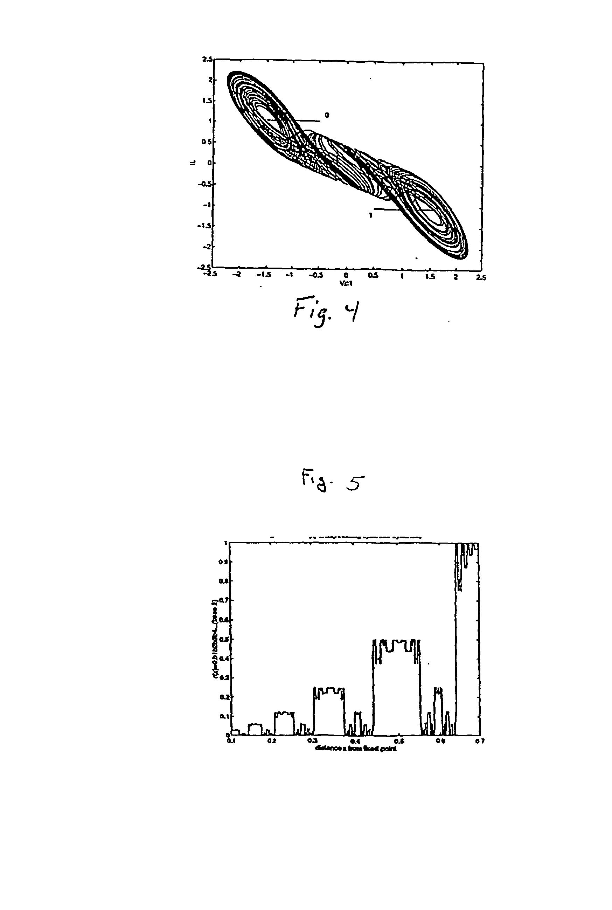

The attractor that results from a numerical simulation using the parameters $C_1$ = 1/9, $C_2$ = 1, $L$ =1/7, $G$ = 0.7, $m_0$ = -0.5, $m_1$ = -0.8, and $B_P$ =1 has two lobes, each of which surrounds an unstable fixed point, as shown in Fig. 4.

Because of the chaotic nature of this oscillator's dynamics, it is possible to take advantage of sensitive dependence on initial conditions by carefully choosing small perturbations to direct trajectories around each of the loops of the oscillator. This ability makes it possible, through the use of an initialization code, to drive the chaotic system onto a periodic orbit that is used to produce a basic waveform.

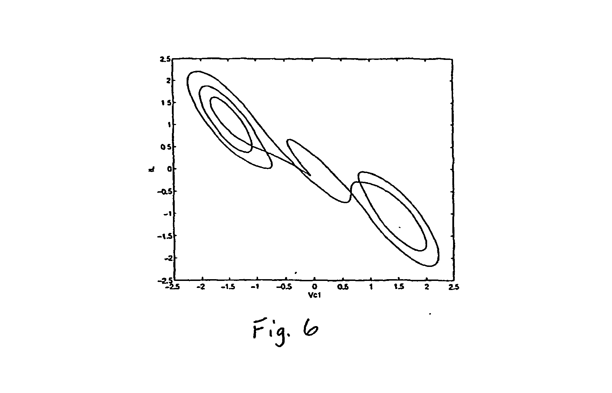

There are a number of means to control the chaotic oscillator. In a preferred embodiment, a Poincare surface of section is defined on each lobe by intersecting the attractor with the half planes $i_L = \pm GF$, $|v_{C1}| \leq F$, where F =$B_p(m_0 - m_1)/(G+m_0)$. When a trajectory intersects one of these sections, the corresponding bit can be recorded. Then, a function r(x) is defined, which takes any point on either section and returns the future symbolic sequence for trajectories passing through that point. If $1_1$, $1_2$, $1_3$,... represent the lobes that are visited on the attractor (so $l_i$ is either a 0 or a 1), and the future evolution of a given point $x_0$ is such that $x_0 \rightarrow l_1, l_2, l_3,..., l_N$ for some number N of loops around the attractor, then the function r(x) is chosen to map $x_0$ to an associated binary fraction, so r($x_0$) =0.$l_1$,$l_2 l_i$ ... $l_N$, where this represents a binary decimal (base 2). Then, when r(x) is calculated for every point on the cross-section, the future evolution of any point on the cross-section is known for N iterations. The resulting function is shown in Fig. 5, where r(x) has been calculated for 12 loops around the attractor.

Control of the trajectory can be used, as it is here, for initialization of the chaotic system and also for transmission of a message. Control of the trajectory begins when it passes through one of the sections, say at $x_0$. The value of r($x_0$) yields the future symbolic sequence followed by the current trajectory for N loops. For the transmission of a message, if a different symbol in the Nth position of the message sequence is desired, r(x) can be searched for the nearest point on the section that will produce the desired symbolic sequence. The trajectory can be perturbed to this new point, and it continues to its next encounter with a surface. This procedure can be repeated as many times as is desirable.

The calculation of r(x) in a preferred embodiment was done discretely by dividing up each of the cross-sections into 2001 partitions ("bins") and calculating the future evolution of the central point in the partition for up to 12 loops around the lobes. As an example, controls were applied so that effects of a perturbation to a trajectory would be evident after only 5 loops around the attractor. In addition to recording r(x), a matrix M was constructed that contains the coordinates for the central points in the bins, as well as instructions concerning the controls at these points. These instructions simply tell how far to perturb the system when it is necessary to apply a control. For example, at an intersection of the trajectory with a cross-section, if r($x_0$) indicates that the trajectory will trace out the sequence 10001, and sequence 10000 is desired, then a search is made for the nearest bin to $x_0$ that will give this sequence, and this information is placed in M. (If the nearest bin is not unique, then there must be an agreement about which bin to take, for example, the bin farthest from the center of the loop.) Because the new starting point after a perturbation has a future evolution sequence that differs from the sequence followed by $x_0$ by at most the last bit, only two options need be considered at each intersection, *control* or *no control.* In an analog hardware implementation of the preferred embodiment, the perturbations are applied using voltage changes or current surges. In a software implementation of the preferred embodiment, the control matrix M would be stored along with the software computing the chaotic dynamics so that when a control perturbation is required, the information would be read from M.

A further improvement involves the use of microcontrols. For a preferred embodiment in software, each time a trajectory of the chaotic system passes through a cross-section, the simulation is backed-up one time step, and the roles of time and space are reversed in the Runge-Kutta solver so that the trajectory can be integrated exactly onto the cross-section without any interpolation. Then, at each intersection where no control is applied, the trajectory is reset so that it starts at the central point of whatever bin it is in. This resetting process can be considered the imposition of microcontrols. It removes any accumulation of round-off error and minimizes the effects of sensitive dependence on initial conditions. It also has the effect of restricting the dynamics of the chaotic attractor to a finite subset of the full chaotic attractor although the dynamics still visit the full phase space. These restrictions can be relaxed by calculating r(x) and M to greater precision at the outset.

As also shown on Fig. 3, the next step 32 in creating the library of initialization codes and basic waveforms is the imposition of an initialization code on the chaotic system. The initialization code drives the chaotic system onto a periodic orbit and stabilizes the otherwise unstable periodic orbit. More specifically, the chaotic system is driven onto a periodic orbit by sending it a repeating code. Different repeating codes lead to different periodic orbits. For a large class of repeating codes, the periodic orbit reached is dependent only on the code segment that is repeated, and not on the initial state of the chaotic system (although the time to get on the periodic orbit can vary depending on the initial state). Consequently, it is possible to send an initialization code that drives the chaotic system onto a known periodic orbit.

These special repeating codes lead to unique periodic orbits for all initial states, so that there is a one-to-one association between a repeating code and a periodic orbit. However, for some repeating codes, the periodic orbits themselves change as the initial state of the chaotic system changes. Consequently, repeating codes can be divided into two classes, initializing codes and non-initializing codes. The length of each periodic orbit is an integer multiple of the length of the repeating code. This is natural, since periodicity is attained only when both the current position on the cross-section *as well as* the current position in the repeating code is the same as at some previous time. To guarantee that the chaotic system is on the desired periodic orbit, it is sufficient that the period of the orbit is exactly the length of the smallest repeated segment of the initializing code.

The number of initializing codes has been compared with the number of bits used in the initialization code, and it appears that the number of initializing codes grows exponentially. This is a promising result, since it means that there are many periodic orbits from which to choose. The compressed initializing code 01011 was repeated for the double-scroll oscillator of a preferred embodiment. The chaotic dynamics in Fig. 4 are driven onto the periodic orbit shown in Fig. 6, which periodic orbit is stabilized by the control code.

As is further shown on Fig. 3, the next step 34 in creating the library is generating a basic waveform, i.e. a one-dimensional, periodic waveform, for each periodic orbit by taking the x-, y-, or z-component (or a combination of them) of the periodic orbit over time. By sampling the amplitude of the waveform over time, e.g. using audio standard PCM 16, one can produce a digital version. These basic waveforms can be highly complex and have strong harmonic structure. The basic waveforms can have more than 50 strong harmonics for some initialization codes, and an important factor that contributes to the performance of the compression technology is the fact that complex basic waveforms with 50 strong harmonics can be produced with the same number of bits in the initialization code as simpler basic waveforms with only a few harmonics. This is indicative of the potential for compression inherent in this system since complex basic waveforms are produced as easily as simple basic waveforms. This is only possible because of the nonlinear chaotic nature of the dynamical system.

The chaotic system can be implemented entirely in software. The chaotic system in such an implementation is defined by a set of differential equations governing the chaotic dynamics, e.g, the double scroll equations described above. The software utilizes an algorithm to simulate the evolution of the differential equations, e.g., the fourth order Runge-Kutta algorithm.

The chaotic system can also be implemented in hardware. The chaotic system is still defined by a set of differential equations, but these equations are then used to develop an electrical circuit that will generate the same chaotic dynamics. The procedure for conversion of a differential equation into an equivalent circuit is well-known and can be accomplished with analog electronics, microcontrollers, embedded CPU's, digital signal processing (DSP) chips, or field programmable gate arrays (FPGA), as well as other devices known to one skilled in the art, configured with the proper feedbacks. The control information is stored in a memory device, and controls are applied by increasing voltage or inducing small current surges in the circuit.

Returning to the flow chart in Fig. 2, at step 22, a section of audio file to be compressed is chosen and analyzed and certain basic waveforms are selected from the library of waveforms. The section of audio file is analyzed and compared to the basic waveforms in the library. The comparison may be effected by extracting key reference information from the section of audio file and correlating it with the information in the catalog file. Those basic waveforms that are most similar, based on selected criteria, to the section of the audio file are then selected and used to build an approximation of the section of the audio file.

There are many approaches that can be employed to compare the basic waveforms and the section of audio file, including a comparison of numbers of zero crossings; number and relative power of harmonics in the frequency spectrum; a projection onto each basic waveform; and geometric comparisons in phase space. The technique chosen is dependent upon the specific application under consideration, but in a preferred embodiment, it has been effective to encapsulate the basic waveform information in a vector that describes the (normalized) magnitudes of the strongest harmonics.

A comparator matrix is created to contain the spectral peaks information for each basic waveform in the library. Then, for a section of audio file, a comparison is made between the spectrum of the section of audio file, and the spectrum of the basic waveforms. In the encapsulated form, the basic waveform that is the closest match can be found merely by taking inner products between the section of audio file vector and the basic waveform vectors of spectral peaks. The best-match basic waveform is selected as the first basis function, along with other close matches and basic waveforms that closely matched the parts of the spectrum that were not fit by the first basis function. In different applications, there may be a variety of approaches to choosing the basic waveforms to keep as basis functions, but the general approach is to project the section of audio file onto the library basic waveforms. Finally, in some applications it is unnecessary or undesirable to keep a library of basic waveforms; in these cases the basic waveforms are recreated as needed by-applying the corresponding initialization codes to the chaotic system.

After the appropriate basic waveforms have been selected, one can begin to approximate the section of audio file. In step 23, all of the selected basic waveforms and the section of audio file are transformed to a proper frequency range, either the audio file range or a fixed reference range, in which a comparison can be made. For example, they can be resampled so that they are in a fixed frequency range. This can be accomplished through standard resampling techniques. Typically, the resampling is done to obtain better resolution of the signals (i.e., upsampling), so no information is lost in the process.

Once the section of audio file and all the waveforms are in the proper frequency range, an approximation, in step 24, is possible. A necessary component is to align the basic waveforms properly with the waveforms of the section of audio file (i.e., adjust the phase), as well as to determine the proper amplification factor or weighting factor (i.e., adjust the amplitude). There are a number of ways this can be done, but the general approach involves a weighted sum of the chosen basic waveforms. The weighting factors are found by minimizing some error criterion or cost function, and will typically involve something equivalent to a least-squares fit to the section of the audio sample. A particularly efficient approach used in a preferred embodiment is to take all of the basic waveforms and split them into a complexified pair of complex conjugate waveforms. This can be accomplished by taking a basic waveform, $f_1$, calculating the fast Fourier transform of the basic waveform, call it $F_1$, then splitting the transform in the frequency domain into positive and negative frequency components $F_{1pos}$, $F_{1neg}$. The positive and negative frequency components are then transformed separately back to the time domain by using the inverse Fourier transform, resulting in a pair of complex conjugate waveforms that vary in the time domain, $f_{1pos}$, and $f_{1neg}$, where $f_{1pos} = (f_{1neg})^*$. The key benefit of the splitting and complexification of the waveforms is that when the complex conjugate waveforms are added together with any complex conjugate pair of weighting factors, the result is a real waveform in the time domain, so if $\alpha$ and $\alpha^*$ are the coefficients, then $\alpha f_{1pos} + \alpha^* f_{1neg}$ is a real function, and if the factors are identically 1 the original function f, is reproduced (adjusted to have zero mean). Further, by choosing $\alpha$ and $\alpha^*$ properly, the phase of the waveform can be automatically adjusted. In practice, all of the phase and amplitude adjustments can be achieved at once for all of the basic waveforms simply by doing a least squares fit to the section of music using the complexified pairs of complex conjugate waveforms derived from the basic waveforms. The weighting functions from the least squares fit are multiplied by the associated waveforms and summed to form the approximation to the music or speech. This approximation can then be tested to determine if the fit is sufficiently good in step 24, and if further improvement is necessary the process can be iterated 25.

The next stage of the compression, step 26, involves examining the approximation and determining if some of the basic waveforms used are unnecessary for achieving a good fit. Unnecessary basic waveforms can be eliminated to improve the compression.

After removing unnecessary basic waveforms, the initialization codes for the remaining basic waveforms, the weighting factors, and the frequency information can be stored in step 27, and then examined in step 28 to determine trends over sections of data. These trends can be predictable, and in test cases have been shown to be well-approximated by piecewise linear functions. When these trends are identified, the weighting factors for many consecutive sections of audio file can be represented by a simple function. This means that the weighting factors do not need to be stored for each section of audio file. This leads to improvements in the compression. Further improvement can be made by making geometric transformations on the space that contains the chaotic attractor, such as through conformal mappings, linear transformations, companding techniques or nonlinear transformations, so that the basic waveforms are altered slightly into a form more suitable for efficient compression. Finally at step 29, the compressed audio file is produced. The compressed audio file can be stored and transmitted using all storage and transmission means available for digital files.

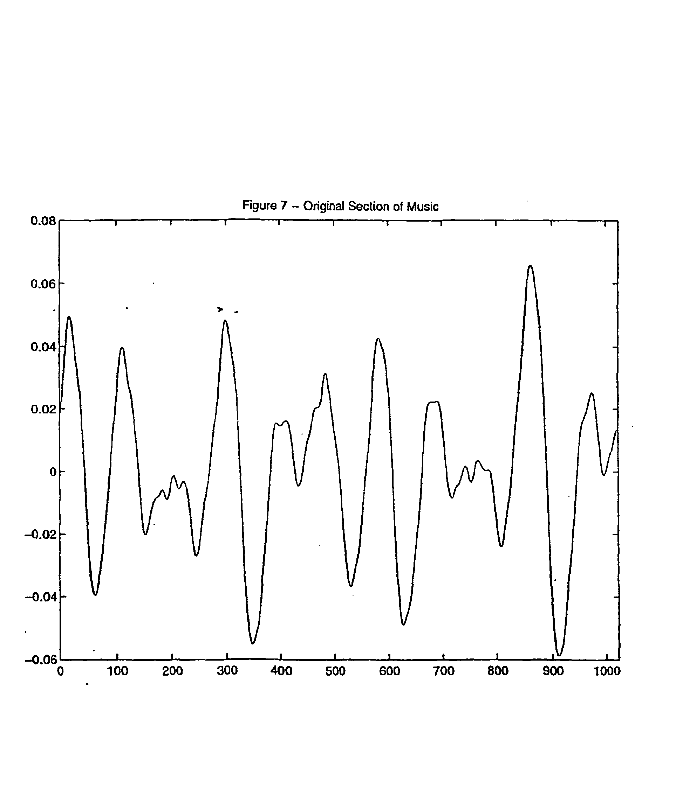

Another preferred embodiment of the present invention is now described in more detail, but there are many variations that produce equivalent results. Fig. 7 shows a section of music, sampled at the standard CD rate of 44,10OHz with 16 bits of amplitude information stored for each sample. In this example, a section of music of length 1024 samples has been chosen, and the entire section is to be compressed. In general, the section length is an adjustable parameter, and in some implementations it would even vary during the compression of a single audio file.

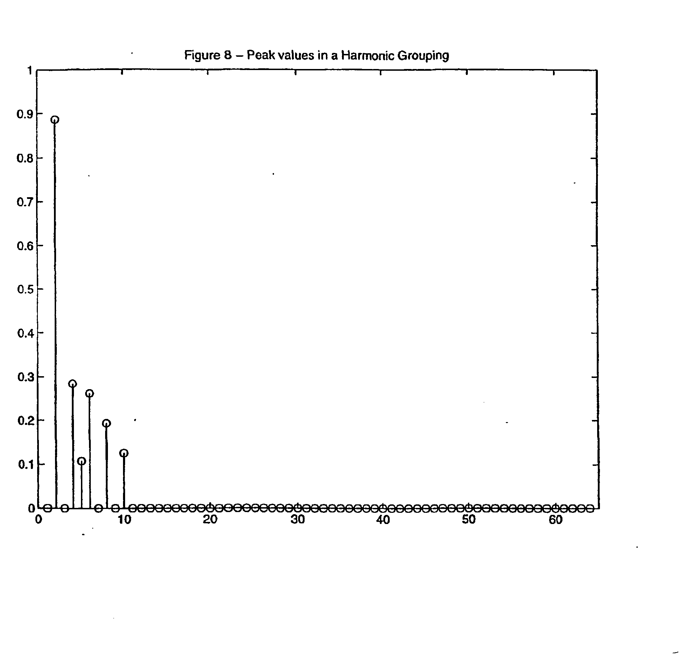

The first step in the process is to analyze the section of music to determine the harmonics present in the section of music. This is done by calculating the fast Fourier transform ("FFT") and then taking the magnitude of the complex Fourier coefficients. The spectrum of coefficients is then searched for peaks, and the peaks are further organized into harmonic groupings. At the first iteration, the harmonic group associated with the maximum signal power is extracted. This is done by determining the frequency of the maximum spectral peak, and then extracting any peaks that are integer multiples of the maximum spectral peak. These peaks are then stored in a vector, $V_{peaks}$, to give the first harmonic grouping. (In practice, further refinement of the harmonic grouping is necessary, since the fundamental or root frequency of a musical note is often not the maximum peak. Rather, the root frequency would be an integer subharmonic of the maximum frequency, so if $F_{max}$ is the frequency with the maximum power, harmonic groups of peaks based on a root frequency of $F_{max}/2$, then $F_{max}/3$, etc. would be extracted, and then the first harmonic group would be that one which captures the greatest power in the peaks. The vector containing the first harmonic grouping is taken to be of length 64 in this embodiment, and, although other implementations may set different lengths, it is necessary to allow for a large number of harmonics in order to capture the complexity of the basic waveforms. Fig. 8 gives a plot of the values in $V_{peaks}$. The goal at the next stage of the compression is to find basic waveforms that have similar harmonic structure to the section of music in question.

The second step in the process is to find basic waveforms in the library of basic waveforms that exhibit similar spectral characteristics. This process is rather simple because the library is established ahead of time and each basic waveform in the library has already been analyzed to determine its harmonic structure. Consequently, for each waveform in the library, a vector of harmonic peaks has been extracted, call these vectors $p_i$, where i varies over all waveforms and assume that 64 peaks have again been taken. These vectors are first normalized to have unit length and are then placed in a matrix, M, that has 64 columns and as many rows as there are waveforms (up to around 27000 in the current embodiment). In order to keep track of which waveform is associated with which row in M, an index table is set up that contains the control code associated with each row in M. Then, to find the closest match to the music vector, $V_{peaks}$, we can calculate the matrix product $X_{projection} = Mv_{peaks}$ and find the maximum value in $X_{projection}$. The row that gives the maximum value corresponds to the basic waveform that matches the section of music most closely. We can then extract the corresponding initialization code from the index table, and we can generate the desired basic waveform or, if the basic waveforms have been stored digitally, we can just load it from the library of basic waveforms. In many instances, it is worthwhile to choose more than one close match to the section of music, since a weighted sum of several basic waveforms is necessary to produce a suitable match; these can be taken by selecting the largest values in $x_{projection}$, and taking the associated basic waveforms indicated in the index table.

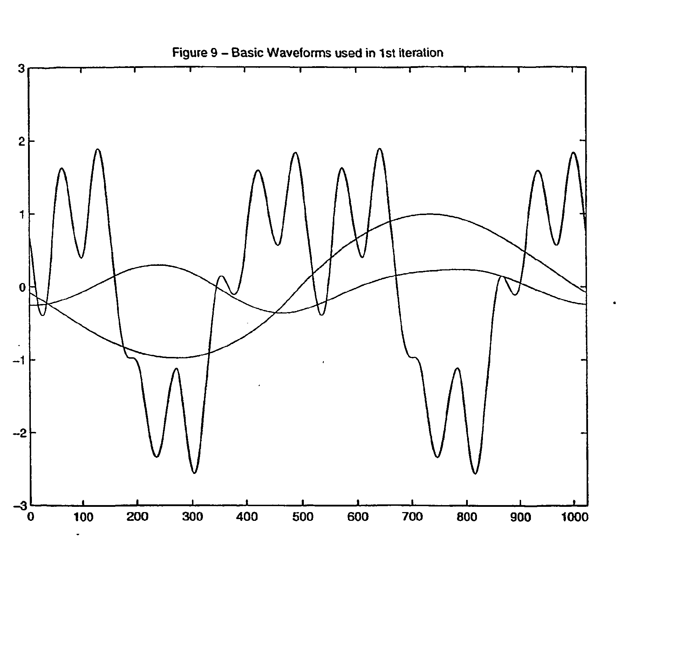

When this approach is applied to the section of music in Fig. 7, the best matches to the section of music are found to be given by control codes $XXXXXXXXX_a$, $YYYYYYYYY_b$, and $ZZZZZZZZZZZ_c$ where the subscript indicates which of the three dimensions in the basic waveform is to be used. One full period of these basic waveforms appears in Fig. 9. The waveforms must next be adjusted so that their periods and phases match that of the music file.

The third step in the process requires adjustment of the period and phase of the basic waveforms. Since the basic waveforms are periodic, the adjustment process can be completed without introducing any errors into the basic waveforms. This can be done entirely in the frequency domain, so the transformations are made to the FFT of the basic waveforms, using standard techniques known in signal processing. The basic waveforms will be adjusted so that the root frequencies of the basic waveforms match the root frequencies of the section of music. To do this, the FFT of the basic waveform is padded with zeros to a length that corresponds to the length of the FFT of the section of music. The complex amplitude of the root frequency of the basic waveform is then shifted up to the root frequency of the section of music, and the remaining harmonics of the root frequency of the basic waveform are shifted up to corresponding multiples of the root frequency of the section of music (the vacated positions are filled with zeros). After the shifting, if the inverse FFT is calculated, the basic waveforms will all have the same root frequency as the section of music; however, the phase of the basic waveforms may not match the phase of the section of music. So, before calculating the inverse FFT, the phase of the chaotic waveforms is adjusted so that the phase of the basic waveform matches the phase of the maximum peak in the section of music.

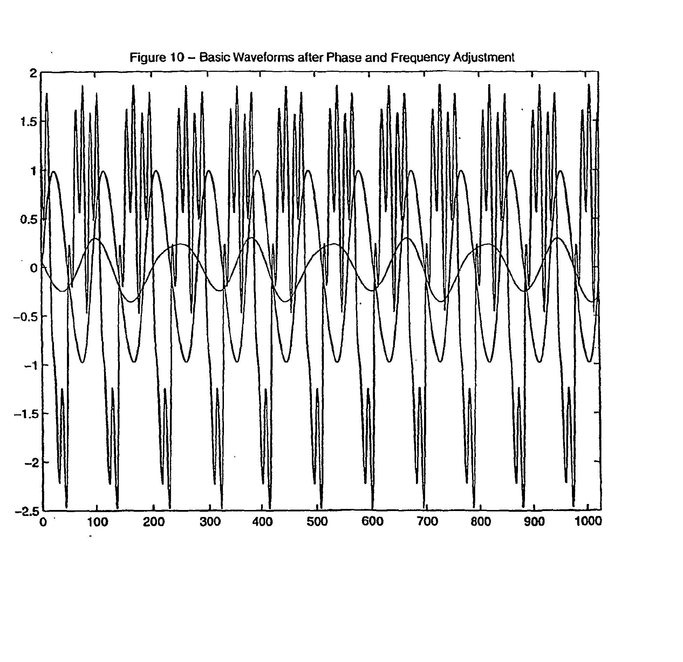

The phase adjustment is achieved by multiplying the complex Fourier amplitudes in the FFT by an appropriate phase factor of the form $e^{i\theta}$ where $\theta$ is chosen to produce the correct phase for the peak corresponding to the maximum peak in the section of music, and the phases of the other spectral peaks are adjusted to produce an overall phase shift of the basic waveform. Note that by multiplying by a phase factor, the overall spectrum of the signal is unchanged. (Different embodiments of the technology use slightly different approaches to the phase adjustment, e.g., one can adjust the phase through filtering, or the phase adjustment can be calculated by a minimization principle designed to minimize the difference between the music and the basic waveform, or by calculating the cross-correlation between the basic waveforms and the section of music. All approaches give roughly equivalent results.) When the phase and frequency adjustments are made to the basic waveforms, the resulting waveforms are depicted in Fig. 10.

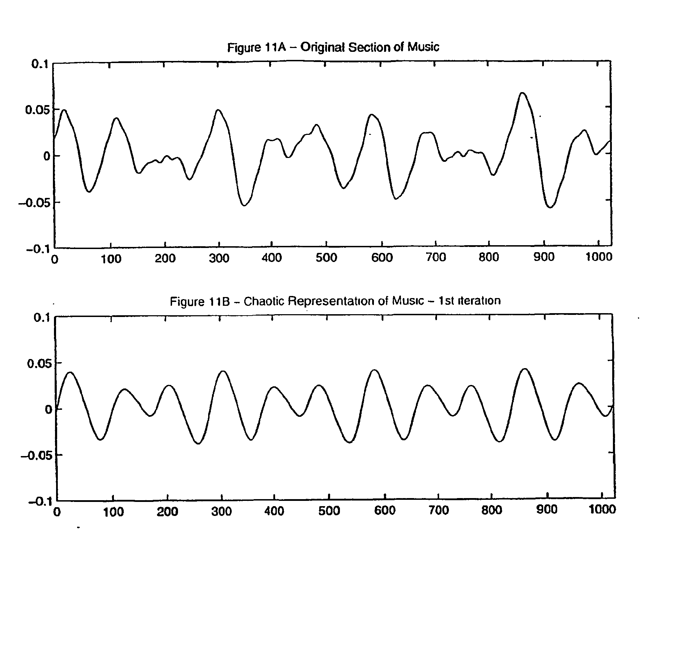

The fourth step in the process is to compute the weighting factors for the sum of basic waveforms that produces the closest match to the section of music. This calculation is done using a least-squares criterion to minimize the residual error between the section of music and the fitted (sum of) basic waveforms. The original section of music appears in Fig. 11A and a first approximation according to the present invention appears in Fig. 11B. The differences are extremely small and so the compressed chaotic version of the music sounds like the original. In the event that the first group of basic waveforms does not produce a close enough match to the section of music, the process is iterated until the desired representation is reached. The compression results from the fact that the compressed chaotic version requires only information about the initialization codes, weighting factors and frequency for a few basic waveforms, rather than 16 bit amplitude information for each of the data points in the section of music.

Another embodiment of the present invention can be used to create compressed speech files. In one embodiment, speech samples from a standard database (the TIMIT database) are projected onto a family of waveforms built up from just 5 fiducial basic waveforms. The comparison of the speech and the waveforms s done at a fixed reference frequency, W, and the processing is done in a comparison block corresponding to N periods at the frequency W. The 5 waveforms are expanded or compressed so that in the comparison block, each fiducial waveform is resampled to produce a family of waveforms containing waveforms with a single period, two periods, three periods, four periods, five periods and six periods, respectively, in the comparison block. A section of the speech file is selected and its power spectrum is computed to find the dominant frequency with the maximum power. The section of speech is then resampled to shift the dominant frequency to the reference frequency W and a number of points corresponding to the length of the comparison block is taken. Note that the resampling is done so that the data is smoothly interpolated, so no information is lost. The section of speech is then approximated using a weighted sum of the waveforms. Each basic waveform is mapped to the corresponding initialization code and stored along with the weighting factors and frequency information in the compressed file. Processing on subsequent sections of the speech follows in a similar fashion. The compressed file can be decompressed to regenerate the (approximation to the) original section of speech, producing intelligible speech.

In a second embodiment, the basic waveforms are fixed, and no adjustments are made to match the frequencies present in the speech. To process a section of a speech file of block length L, a family of basic waveforms is selected and each basic waveform is recomputed to produce over the block length L, a single period, two full periods, three full periods, ..., up to 6 full periods. Each basic waveform is then "twinned" to form an analog of a sine-cosine pair. This is achieved by taking each basic waveform and calculating the autocorrelation function. The first zero of the autocorrelation function defines a time lag such that if we take the basic waveform and a copy of itself that is shifted by the time lag, then the basic waveform and its shifted version are independent in an information theoretic sense. This family of basic waveforms can then be used to represent the section of speech, so that a compressed speech file is produced The decompressed version of the compressed file produces intelligible speech. The high compression ratios may make practical Internet telephony that maintains fidelity possible.

## Claims

1. A method of compressing a data signal, using a chaotic system, comprising:

   a. causing (32) the chaotic system to assume periodic orbits by applying initialization codes to the chaotic system;
   b. generating (34) periodic waveforms for the periodic orbits;
   c. weighting (24) the periodic waveforms to approximate at least a portion of the data signal; and
   d. producing (27) a compressed representation of the portion of the data signal from a combination of at least one initialization code and a representation of the weighting.

2. The method of claim 1, including stabilizing the periodic orbit.

3. The method of claim 1, including:

   identifying (28) a trend over portions of the data signal; and
   defining a relationship between weighting factors in the portions of the data signal.

4. The method of claim 3, wherein identifying the trend includes determining a mathematical model for the trend.

5. The method of claim 3, including producing (27) a compressed representation of the portion of the data signal from a combination of the trend, the at least one initialization code, and the representation of the weighting.

6. The method of claim 1, wherein the data signal comprises audio data.

7. The method of claim 1, further comprising transforming the portion of the data signal and the generated periodic waveforms to a suitable frequency range and storing frequency information describing the transformation, and including the frequency information in the combination of the at least the initialization code and the representation of the weighting.

8. The method of claim 1, further comprising assigning a weighting of zero to any of the generated periodic waveforms not deemed necessary to approximate sufficiently well the portion of the data signal.

9. The method of claim 9, further comprising removing from the weighted sum of the generated periodic waveforms the initialization code of any periodic waveform having zero weighting.

10. A method of decompressing a compressed representation of a first data signal, the compressed representation produced using a first chaotic system and containing a combination of at least an initialization code and a representation of a weighting, comprising:

a. receiving at a second chaotic system, substantially identical to the first chaotic system, the combination of at least the initialization code and the representation of a weighting;
b. causing the second chaotic system to assume periodic orbits by applying the initialization code from the combination;
c. generating periodic waveforms for the periodic orbits; and
d. applying to the periodic waveforms the weighting to produce a second data signal substantially identical to at least a portion of the first data signal.

11. The method of claim 10, including stabilizing the periodic orbit.

12. The method of claim 10, wherein the compressed representation includes trend information for the at least a portion of the first data signal.

13. The method of claim 12, including applying the trend information to the at least a portion of the second data signal, to substantially reproduce the at least a portion of the first data signal.

14. The method of claim 12, wherein the trend information includes a mathematical model of the trend.

15. The method of claim 10, wherein the data signal comprises audio data.

16. The method of claim 10, further comprising:

causing the second chaotic system to assume a plurality of periodic orbits by applying a plurality of initialization codes to the second chaotic system;
generating a periodic waveform for each of a subset of the periodic orbits; and
applying the weighting to the generated periodic waveforms to produce at least a portion of a second data signal substantially identical to at least a portion of the first data signal.

17. The method of claim 16, wherein applying the weighting includes

applying, to a first portion of the second data signal, a predetermined correlation between data in the first portion of the first data signal and data in at least one other portion of the first data signal, to produce at least one other portion of the second data signal substantially identical to the at least one other portion of the first data signal.

18. A computer program product for compressing a data signal, which when executed on a computing device performs the steps of claim 1.

19. A computer program product for decompressing a compressed representation of a first data signal, which when executed on a computing device performs the steps of claim 10.

20. A data signal compressor using a chaotic system, comprising:

a. means (2) for causing the chaotic system to assume periodic orbits by applying initialization codes to the chaotic system (3);
b. means for generating periodic waveforms for the periodic orbits;
c. means (7) for weighting the periodic waveforms to approximate at least a portion of the data signal; and
d. means for producing a compressed representation of the portion of the data signal from a combination of at least one initialization code and a representation of the weighting.

21. A signal decompressor operable on a compressed representation of a first data signal (5), the compressed representation produced using a first chaotic system (3) and containing a combination of at least an initialization code and a representation of a weighting, comprising:

a. means (9) for receiving at a second chaotic system (10), substantially identical to the first chaotic system, the combination of at least the initialization code and the representation of a weighting;

b. means for causing the second chaotic system to assume periodic orbits by applying the initialization code from the combination;

c. means for generating periodic waveforms for the periodic orbits; and

d. means (11) for applying to the periodic waveforms the weighting to produce a second data signal substantially identical to at least a portion of the first data signal.

**Patentansprüche**

1. Verfahren zum Komprimieren eines Datensignals mit einem chaotischen System, das die folgenden Schritte beinhaltet:

   a. Bewirken (32), dass das chaotische System periodische Orbits annimmt, durch Anwenden von Initialisierungscodes auf das chaotische System;

   b. Erzeugen (34) periodischer Wellenformen für die periodischen Orbits;

   c. Gewichten (24) der periodischen Wellenformen, um wenigstens einen Teil des Datensignals zu approximieren; und

   d. Erzeugen (27) einer komprimierten Repräsentation des Teils des Datensignals von einer Kombination von wenigstens einem Initialisierungscode und einer Repräsentation der Gewichtung.

2. Verfahren nach Anspruch 1, das das Stabilisieren des periodischen Orbits beinhaltet.

3. Verfahren nach Anspruch 1, das Folgendes beinhaltet:

   Identifizieren (28) eines Trends über Teile des Datensignals; und
   Definieren einer Beziehung zwischen Gewichtungsfaktoren in den Teilen des Datensignals.

4. Verfahren nach Anspruch 3, wobei das Identifizieren des Trends das Ermitteln eines mathematischen Modells für den Trend beinhaltet.

5. Verfahren nach Anspruch 3, das das Erzeugen (27) einer komprimierten Repräsentation des Teils des Datensignals von einer Kombination aus dem Trend, dem wenigstens einen Initialisierungscode und der Repräsentation der Gewichtung beinhaltet.

6. Verfahren nach Anspruch 1, wobei das Datensignal Audiodaten umfasst.

7. Verfahren nach Anspruch 1, das ferner das Transformieren des Teils des Datensignals und der erzeugten periodischen Wellenformen auf einen geeigneten Frequenzbereich und das Speichern von die Transformation beschreibenden Frequenzinformationen sowie das Einbeziehen der Frequenzinformationen in die Kombination aus dem wenigstens einen Initialisierungscode und der Repräsentation der Gewichtung beinhaltet.

8. Verfahren nach Anspruch 1, das ferner das Zuweisen einer Gewichtung von null zu beliebigen der erzeugten periodischen Wellenformen beinhaltet, die nicht als notwendig angesehen werden, um den Teil des Datensignals ausreichend gut zu approximieren.

9. Verfahren nach Anspruch 9, das ferner das Entfernen des Initialisierungscodes einer beliebigen periodischen Wellenform mit einer Gewichtung von null aus der gewichteten Summe der erzeugten periodischen Wellenformen beinhaltet.

10. Verfahren zum Dekomprimieren einer komprimierten Repräsentation eines ersten Datensignals, wobei die mit einem ersten chaotischen System erzeugte komprimierte Repräsentation, die eine Kombination aus wenigstens einem Initialisierungscode und einer Repräsentation einer Gewichtung enthält, Folgendes umfasst:

    a. Empfangen an einem zweiten chaotischen System, das mit dem ersten chaotischen System im Wesentlichen identisch ist, der Kombination aus wenigstens dem Initialisierungscode und der Repräsentation einer Gewichtung;

b. Bewirken, dass das zweite chaotische System periodische Orbits annimmt, durch Anwenden des Initialisierungscodes aus der Kombination;

c. Erzeugen periodischer Wellenformen für die periodischen Orbits; und

d. Anwenden der Gewichtung auf die periodischen Wellenformen, um ein zweites Datensignal zu erzeugen, das mit wenigstens einem Teil des ersten Datensignals im Wesentlichen identisch ist.

**11.** Verfahren nach Anspruch 10, das das Stabilisieren des periodischen Orbits beinhaltet.

**12.** Verfahren nach Anspruch 10, wobei die komprimierte Repräsentation Trendinformationen für den wenigstens einen Teil des ersten Datensignals beinhaltet.

**13.** Verfahren nach Anspruch 12, das das Anwenden der Trendinformationen auf den wenigstens einen Teil des zweiten Datensignals beinhaltet, um im Wesentlichen den wenigstens einen Teil des ersten Datensignals zu reproduzieren.

**14.** Verfahren nach Anspruch 12, wobei die Trendinformationen ein mathematisches Modell des Trends beinhalten.

**15.** Verfahren nach Anspruch 10, wobei das Datensignal Audiodaten beinhaltet.

**16.** Verfahren nach Anspruch 10, das ferner die folgenden Schritte beinhaltet:

Bewirken, dass das zweite chaotische System mehrere periodische Orbits annimmt, durch Anwenden einer Mehrzahl von Initialisierungscodes auf das zweite chaotische System;

Erzeugen einer periodischen Wellenform für jeden aus einer Teilmenge der periodischen Orbits; und

Anwenden der Gewichtung auf die erzeugten periodischen Wellenformen, um wenigstens einen Teil des zweiten Datensignals zu erzeugen, der mit dem wenigstens einen Teil des ersten Datensignals im Wesentlichen identisch ist.

**17.** Verfahren nach Anspruch 16, wobei das Anwenden der Gewichtung das Anwenden einer vorbestimmten Korrelation zwischen Daten im ersten Teil des ersten Datensignals und Daten in wenigstens einem anderen Teil des ersten Datensignals auf einen ersten Teil des zweiten Datensignals beinhaltet, um wenigstens einen weiteren Teil des zweiten Datensignals zu erzeugen, der mit dem wenigstens einen anderen Teil des ersten Datensignals im Wesentlichen identisch ist.

**18.** Computerprogrammprodukt zum Komprimieren eines Datensignals, das bei Ausführung auf einem Computergerät die Schritte von Anspruch 1 ausführt.

**19.** Computerprogrammprodukt zum Dekomprimieren einer komprimierten Repräsentation eines ersten Datensignals, das bei Ausführung auf einem Computergerät die Schritte von Anspruch 10 ausführt.

**20.** Datensignalkompressor, der ein chaotisches System verwendet und Folgendes umfasst:

a. Mittel (2), um zu bewirken, dass das chaotische System periodische Orbits annimmt, durch Anwenden von Initialisierungscodes auf das chaotische System (3);

b. Mittel zum Erzeugen periodischer Wellenformen für die periodischen Orbits;

c. Mittel (7) zum Gewichten der periodischen Wellenformen, um wenigstens einen Teil des Datensignals zu approximieren; und

d. Mittel zum Erzeugen einer komprimierten Repräsentation des Teils des Datensignals von einer Kombination aus wenigstens einem Initialisierungscode und einer Repräsentation der Gewichtung.

**21.** Signaldekompressor, der auf eine komprimierte Repräsentation eines ersten Datensignals (5) angewendet werden kann, wobei die erzeugte komprimerte Repräsentation ein erstes chaotisches System (3) verwendet und eine Kombination aus wenigstens einem Initialisierungscode und einer Repräsentation einer Gewichtung enthält und Folgendes umfasst:

a. Mittel (9) zum Empfangen an einem zweiten chaotischen System (10), das mit dem ersten chaotischen System im Wesentlichen identisch ist, der Kombination aus wenigstens dem Initialisierungscode und der Repräsentation einer Gewichtung;

b. Mittel, um zu bewirken, dass das zweite chaotische System periodische Orbits annimmt, durch Anwenden des Initialisierungscodes aus der Kombination;

c. Mittel zum Erzeugen periodischer Wellenformen für die periodischen Orbits; und

d. Mittel (11) zum Anwenden der Gewichtung auf die periodischen Wellenformen, um ein zweites Datensignal zu erzeugen, das mit wenigstens einem Teil des ersten Datensignals im Wesentlichen identisch ist.

**Revendications**

1. Un procédé de compression d'un signal de données au moyen d'un système chaotique comprenant :

   a. le fait d'amener (32) le système chaotique à adopter des orbites périodiques en appliquant des codes d'initialisation au système chaotique,
   b. la génération (34) de formes d'onde périodiques pour les orbites périodiques,
   c. la pondération (24) des formes d'onde périodiques afin d'approximer au moins une partie du signal de données, et
   d. la production (27) d'une représentation compressée d'une partie du signal de données à partir d'une combinaison d'au moins un code d'initialisation et d'une représentation de la pondération.

2. Le procédé selon la Revendication 1 comprenant la stabilisation de l'orbite périodique.

3. Le procédé selon la Revendication 1 comprenant :

   l'identification (28) d'une tendance sur des parties du signal de données, et
   la définition d'une relation entre des facteurs de pondération dans les parties du signal de données.

4. Le procédé selon la Revendication 3 où l'identification de la tendance comprend la détermination d'un modèle mathématique pour la tendance.

5. Le procédé selon la Revendication 3 comprenant la production (27) d'une représentation compressée de la partie du signal de données à partir d'une combinaison de la tendance, du au moins un code d'initialisation et de la représentation de la pondération.

6. Le procédé selon la Revendication 1 où le signal de données comprend des données audio.

7. Le procédé selon la Revendication 1 comprenant en outre la transformation de la partie du signal de données et des formes d'onde périodiques générées en une gamme de fréquences adaptée et la mise en mémoire d'informations de fréquence décrivant la transformation, et incluant les informations de fréquence dans la combinaison du au moins un code d'initialisation et de la représentation de la pondération.

8. Le procédé selon la Revendication 1 comprenant en outre l'attribution d'une pondération nulle à toute forme d'onde périodique générée non jugée nécessaire pour approximer suffisamment bien la partie du signal de données.

9. Le procédé selon la Revendication 9 comprenant en outre le retrait de la somme pondérée des formes d'onde périodiques générées du code d'initialisation de toute forme d'onde périodique possédant une pondération nulle.

10. Un procédé de décompression d'une représentation compressée d'un premier signal de données, la représentation compressée étant produite en utilisant un premier système chaotique et contenant une combinaison d'au moins un code d'initialisation et d'une représentation d'une pondération, comprenant :

    a. la réception sur un deuxième système chaotique, substantiellement identique au premier système chaotique, de la combinaison d'au moins le code d'initialisation et de la représentation d'une pondération,
    b. le fait d'amener le deuxième système chaotique à adopter des orbites périodiques en appliquant le code d'initialisation provenant de la combinaison,
    c. la génération de formes d'onde périodiques pour les orbites périodiques, et
    d. l'application aux formes d'onde périodiques de la pondération afin de produire un deuxième signal de données substantiellement identique à au moins une partie du premier signal de données.

11. Le procédé selon la Revendication 10 comprenant la stabilisation de l'orbite périodique.

**12.** Le procédé selon la Revendication 10 où la représentation compressée inclut des informations de tendance pour la au moins une partie du premier signal de données.

**13.** Le procédé selon la Revendication 12 comprenant l'application des informations de tendance à la au moins une partie du deuxième signal de données afin de reproduire substantiellement la au moins une partie du premier signal de données.

**14.** Le procédé selon la Revendication 12 où les informations de tendance comprennent un modèle mathématique de la tendance.

**15.** Le procédé selon la Revendication 10 où le signal de données comprend des données audio.

**16.** Le procédé selon la Revendication 10 comprenant en outre :

le fait d'amener le deuxième système chaotique à adopter une pluralité d'orbites périodiques en appliquant une pluralité de codes d'initialisation au deuxième système chaotique,
la génération d'une forme d'onde périodique pour chaque orbite périodique d'un sous-ensemble des orbites périodiques, et
l'application de la pondération aux formes d'onde périodiques générées afin de produire au moins une partie d'un deuxième signal de données substantiellement identique à au moins une partie du premier signal de données.

**17.** Le procédé selon la Revendication 16 où l'application de la pondération comprend :

l'application à une première partie du deuxième signal de données d'une corrélation prédéterminée entre des données de la première partie du premier signal de données et des données d'au moins une autre partie du premier signal de données afin de produire au moins une autre partie du deuxième signal de données substantiellement identique à la au moins une autre partie du premier signal de données.

**18.** Un programme informatique destiné à compresser un signal de données qui, lorsqu'il est exécuté sur un dispositif informatique, exécute les opérations de la Revendication 1.

**19.** Un programme informatique destiné à décompresser une représentation compressée d'un premier signal de données qui, lorsqu'il est exécuté sur un dispositif informatique, exécute les opérations de la Revendication 10.

**20.** Un compresseur de signaux de données au moyen d'un système chaotique comprenant :

a. un moyen (2) d'amener le système chaotique à adopter des orbites périodiques en appliquant des codes d'initialisation au système chaotique (3),
b. un moyen de générer des formes d'onde périodiques pour les orbites périodiques,
c. un moyen (7) de pondérer les formes d'onde périodiques afin d'approximer au moins une partie du signal de données, et
d. un moyen de produire une représentation compressée de la partie du signal de données à partir d'une combinaison d'au moins un code d'initialisation et d'une représentation de la pondération.

**21.** Un décompresseur de signaux utilisable sur une représentation compressée d'un premier signal de données (5), la représentation compressée étant produite au moyen d'un premier système chaotique (3) et contenant une combinaison d'au moins un code d'initialisation et d'une représentation d'une pondération, comprenant :

a. un moyen (9) de recevoir sur un deuxième système chaotique (10), substantiellement identique au premier système chaotique, la combinaison d'au moins le code d'initialisation et de la représentation d'une pondération,
b. un moyen d'amener le deuxième système chaotique à adopter des orbites périodiques en appliquant le code d'initialisation provenant de la combinaison,
c. un moyen de générer des formes d'onde périodiques pour les orbites périodiques, et
d. un moyen (11) d'appliquer aux formes d'onde périodiques la pondération afin de produire un deuxième signal de données substantiellement identique à au moins une partie du premier signal de données.

**14**

Figure 1
1/10

Create library of
basic waveforms
and
corresponding
initialization codes  **20**

**18**

Analyze audio
and select similar
basic waveforms  **22**

Transform audio
and basic
waveforms to
frequency range  **23**

Approximate
audio as a
weighted sum of
basic waveforms  **24**

Remove basic
waveforms
unnecessary
for good fit  **26**

Store basic
waveforms,
initializing codes and
frequency information  **27**

Examine weighting
factors and look for
compressible or
predictable patterns  **28**

Output audio
compressed
file  **29**

## Figure 2

16

Choosing a chaotic system | 30

Imposing an initialization code on the chaotic system to drive it onto a periodic orbit | 32

Generating a basic waveform from the periodic orbit | 34

# Figure 3

Fig. 4

Fig. 5

Fig. 6

Figure 7 – Original Section of Music

Figure 8 – Peak values in a Harmonic Grouping

Figure 9 – Basic Waveforms used in 1st iteration

Figure 10 – Basic Waveforms after Phase and Frequency Adjustment

Figure 11A – Original Section of Music

Figure 11B – Chaotic Representation of Music – 1st iteration

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5432697 A
- US 6363153 B
- US 6137045 A

**Non-patent literature cited in the description**

- **DEDIEU H et al.** Signal coding and compression based on chaos control techniques. *IEEE Symposium on Circuits and Systems,* 28 April 1995, vol. 2, 1191-1194
- **SHORT et al.** *Method and Apparatus for Secure Digital Chaotic Communication*
- **SHORT et al.** *Method and Apparatus for Compressed Chaotic Music Synthesis*
- **S. HAYES ; C. GREBOGI ; E. OTT.** *Communicating with Chaos, Phys, Rev. Lett.,* 1993, vol. 70, 3031